# EUROPEAN PATENT APPLICATION

(11) **EP 3 916 813 A1**
(43) Date of publication of application: **01.12.2021**
(21) Application number: 19927345.9
(22) Date of filing: 13.05.2019
(51) Int. Cl.: H01L 31/0216

(54) **DOUBLE-SIDED POWER GENERATION SOLAR CELL AND FABRICATING METHOD THEREFOR**

(30) Priority: 29.04.2019 CN 201910353961
(71) Applicant: Nantong T-Sun New Energy Co., Ltd., Nantong, Jiangsu 226010 (CN)
(72) Inventor: ZHU, Peng, Nantong, Jiangsu 226000 (CN); LIU, Yuan, Nantong, Jiangsu 226000 (CN); WU, Guang, Nantong, Jiangsu 226000 (CN); ZHENG, Jinhua, Nantong, Jiangsu 226000 (CN)
(74) Representative: Sun, Yiming
(86) International application number: PCT/CN2019/086564
(87) International publication number: WO 2020/220394

(57) **Abstract**

The present invention discloses a rear-passivated solar cell comprising a rear electrode, an all-aluminum back surface electric field, a rear passivation layer, a local aluminum back surface field, a P-type silicon, an N-type emission electrode, a passivation coating and a front electrode, wherein the rear electrode, the all-aluminum back surface electric field, the rear passivation layer, the P-type silicon, the N-type emission electrode, the passivation coating and the front electrode are connected in a bottom-to-top sequence; the local aluminum back surface field is formed by etching the rear passivation layer with an inorganic etching paste and sintering; the local aluminum back surface field is a set of linearly arranged grid lines of aluminum paste and is uniformly distributed in the rear passivation layer. The solar cell of the present invention is characterized by an improved photoelectric conversion efficiency, high controllability, reduced costs of both equipment and pastes, a simple production process, a high production efficiency, and good compatibility with existing production lines.

## Description

### TECHNICAL FIELD

The present invention relates to the technical field of photovoltaics, and in particular to a double-sided solar cell and a method for preparing the same.

### BACKGROUND

Photovoltaics is a technology for converting solar energy into electrical energy using a large area of p-n junction diodes. The p-n junction diode is called a solar cell. Semiconductive materials used for preparing solar cells have certain band gaps. When a solar cell is exposed to solar radiation, photons with energy exceeding the band gap cause electron-hole pairs in the solar cell, which are separated by the p-n junctions. The asymmetry of the p-n junction determines the flowing direction of different types of photon-generated carriers. Through connection of an external circuit, power can be output. This is similar in principle to a conventional electrochemical cell.

In the industrial production of P-type crystalline silicon solar cells, an all-aluminum back surface field structure formed by fully printing with an aluminum paste on the rear and sintering is employed. Such structure has the disadvantage of having no rear passivation and low rear reflectivity, which affects the voltage and current performance of the cell. Cells with local aluminum back surface field avoid the above disadvantages by using a thin film passivation back surface with passivation effect and increasing the reflectivity of the back surface. The passivation coating effectively passivates a large number of dangling bonds and defects (such as dislocation, grain boundaries, and point defects) on the surface of the silicon material, thereby reducing the recombination rate of the photon-generated carriers on the silicon surface, prolonging the effective lifetime of a minority of carriers, and further facilitating the improvement of photoelectric conversion efficiency of the solar cell. In addition, the passivation coating has the effect of increasing rear reflection, which facilitates the absorption of sunlight by the silicon material. As a result, the concentration of the photon-generated carriers and thus the photocurrent density areincreased.

Chinese Patent No. CN104362189B discloses a rear-passivated solar cell and a method for preparing the same. In that invention, the rear passivation layer is etched with an aluminum etching paste, and a local aluminum back surface field is formed by printing a rear aluminum paste. The rear-passivated solar cell prepared according to this method has disadvantages of excessive use of aluminum paste, low cost-efficiency and incomplete etching by the aluminum etching paste, and can provide power generation on only one side.

Chinese Patent No. CN103489934A discloses a double-sided transparent local back surface field crystalline silicon solar cell, wherein the back surface electric field of the solar cell is a local aluminum back surface field, and the rear passivation coating is perforated or grooved by laser or chemical etching. However, the costs of laser perforation or grooving are high, and additional equipment for laser grooving is further required in the production line, leading to higher costs; the chemical etching by acid has great damage to the solar cell, and thus a costly subsequent cleaning process is required.

### SUMMARY

Purpose: In order to solve the defects in the prior art, the present invention provides a double-sided solar cell and a method for preparing the same. The solar cell is provided with a local aluminum back surface field by etching the passivation coating on the back surface of the crystalline silicon with an inorganic etching paste, which has a low burning-through temperature. The etching by the inorganic etching paste is more homogeneous than that by the etching aluminum, and needs no subsequent cleaning process compared to that by acid, thereby simplifying the process and thus improving the photoelectric conversion efficiency of the solar cell. Moreover, printing a highly conductive aluminum paste on the inorganic etching paste layer can further improve the conversion efficiency.

Technical Scheme: The first purpose of the present invention is to provide a double-sided solar cell, comprising a silicon substrate; an N-type emission electrode, a font-side passivation anti-reflection coating and a front electrode arranged in a bottom-to-top sequence on a front of the silicon substrate; and a rear passivation coating, a back surface electric field and a rear electrode arranged in a bottom-to-top sequence on a rear of the silicon substrate, wherein the solar cell is a double-sided solar cell; the back surface electric field is a local aluminum back surface electric field; the local aluminum back surface electric field is provided with linear grooves by etching the rear passivation coating with an inorganic etching paste, and the grooves are covered with a highly conductive aluminum paste; the solar cell has a BSF layer of 2-5 µm thick.

In one preferred embodiment of the present invention, the inorganic etching paste is an inorganic non-metal etching paste.

In one preferred embodiment of the present invention, the local aluminum back surface field (2) comprises a set of parallel straight strip groups uniformly distributed in the rear passivation coating (1); the grooves on the local aluminum back surface electric field (2) have a width of 10-25 µm and an etching depth of 120-150 nm, and a distance between two adjacent grooves of 0.6-1 mm.

In one preferred embodiment of the present invention, the highly conductive aluminum paste has conductivity of 1 × 10⁻⁶-2 × 10⁻⁵ Ω·cm; the linear highly conductive aluminum paste has a width of 15-50 µm, and a distance between two adjacent linear highly conductive aluminum pastes of 0.6-2 mm.

In one preferred embodiment of the present invention, the silicon substrate (5) is a P-type crystalline silicon wafer, and the P-type silicon is formed by slicing a crystal bar generated by growth of a P-type silicon starting material crystal.

Another purpose of the present invention is to provide method for preparing a double-sided solar cell, comprising:
S1, silicon wafer selection, texturing, and cleaning: selecting a P-type silicon having a size of 156 × 156 mm, and forming a textured surface on a front of the P-type silicon wafer by wet or dry etching with the reflectivity controlled at 10-30%;
S2, phosphorus diffusion: performing phosphorus diffusion on the front of the silicon wafer treated in S1, and forming an N-type emission electrode, for example, by thermal diffusion or ion implantation, wherein the diffusion of the silicon wafer is preferably performed using phosphorus oxychloride, and the sheet resistance is controlled at 75-100 ohm/sq during the diffusion;
S3, back junction removal: removing phosphorosilicate glass formed in the diffusion process on the basis of S2, and removing a phosphorosilicate glass layer formed in the diffusion process on a front of the N-type emission electrode and a rear of the P-type silicon wafer with an HF solution;
S4, deposition of a rear passivation coating: depositing an 8-12-nm thick layer of aluminum oxide or silicon dioxide on the rear of the silicon wafer using a PVECD device, depositing a 70-80-nm thick layer of silicon nitride on the aluminum oxide layer or silicon dioxide layer using a PVECD device to finally form a rear passivation layer;
S5, deposition of a front anti-reflection passivation coating: forming a silicon nitride anti-reflection passivation coating on the front of the silicon wafer;
S6, rear electrode printing, and grooves etching on the rear passivation coating by printing an organic etching paste: printing an inorganic etching paste on the rear of the silicon wafer by screen printing or ink-jet printing, wherein the inorganic etching paste is parallel printed on the rear passivation layer and dried; the inorganic etching paste etches the rear passivation layer in a sintering process at 300-450 °C, and the aluminum paste fills the straight grooves to form a local aluminum back surface field for connecting an all-aluminum back surface electric field and the P-type silicon;
S7, groove covering with a linear aluminum paste, and front electrode printing: printing a linear highly conductive aluminum paste in the grooves on the rear of the silicon wafer to cover the inorganic etching paste to form a local aluminum back surface field and drying, and printing a rear electrode silver paste on the rear of the silicon wafer and drying; and
S8, sintering to give a local aluminum back surface field: sintering the silicon wafer at a high temperature, during which the inorganic etching paste etches the rear passivation layer to form the local aluminum back surface field for connecting the all-aluminum back surface electric field and the P-type silicon.

In one preferred embodiment of the present invention, the thickness of the Al₂O₃ or the SiOₓ layer in S4 is 2-12 nm, and the thickness of the SiNₓ layer is 70-100 nm.

In one preferred embodiment of the present invention, the groove etching temperature of the inorganic etching paste in S6 is 200-450 °C.

In one preferred embodiment of the present invention, the sintering temperature of the aluminum paste in S8 is 730-770 °C.

Beneficial Effects: The present invention has the following advantages:
(1) According to the double-sided solar cell of the present invention, the grooves on the aluminum back surface electric field have a width of 10-25 µm, the grooves on the local aluminum back surface electric field have a depth of 120-150 nm and a distance between two adjacent grooves of 0.6-1 mm; the linear aluminum paste has a width of 15-30 µm and a distance between two adjacent linear aluminum pastes of 0.6-1 mm. The small groove width in the local aluminum back surface field causes less metal recombination, and thus the photoelectric conversion efficiency of the solar cell of the present invention is improved. The solar cell has a BSF layer of 2-5 µm thick, which enables an increase in thickness of the BSF layer, and leads to less damage to the silicon substrate and less consumption of aluminum paste, thereby improving the photoelectric conversion efficiency.
(2) According to the method for preparing the double-sided solar cell, the local aluminum back surface electric field is provided with linear grooves by etching the rear passivation coating with an inorganic etching paste. The etching paste is inexpensive. It has a low sintering temperature of 200-450 °C for the rear passivation layer, and thus is energetically economical. Use of etching paste is reduced, thus resulting in a economical use of solar cells. The etching by the inorganic etching paste on the rear passivation coating is uniform, and thus good contact is formed. After etching, subsequent cleaning by organic solvent is not needed, which facilitates the process.

### BRIEF DESCRIPTION OF THE DRAWING

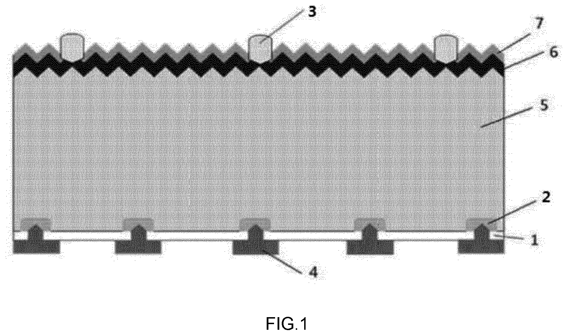

FIG. 1 is a structural schematic of the double-sided solar cell of the present invention;
1-rear passivation coating; 2-local aluminum back surface field; 3-front electrode; 4-rear electrode; 5-silicon substrate; 6-emission electrode; and 7-front anti-reflection passivation coating.

### DETAILED DESCRIPTION

The technical schemes in the embodiments of the present invention will be clearly and completely described below, for a better understanding of the advantages and features of the present invention by those skilled in the art, and for a more the clearly defined protection scope of the present invention. The described embodiments are only some, but not all, embodiments of the invention. Based on the embodiments of the present invention, all other embodiments obtained by those of ordinary skill in the art without making any creative effort will fall within the protection scope of the present invention.

As shown in FIG. 1, the back passivation solar cell of the present invention comprises a rear passivation coating 1, a local aluminum back surface field 2, a front electrode 3, a rear electrode 4, a silicon substrate 5, an N-type emission electrode 6 and a front anti-reflection passivation coating 7; the rear electrode 4, the local aluminum back surface field 2, the rear passivation coating 1, the silicon substrate 5, the N-type emission electrode 6, the front anti-reflection passivation coating 7 and the front electrode 3 are connected in a bottom-to-top sequence, and the local aluminum back surface field 2 is formed by etching the rear passivation layer 1 with an inorganic etching paste and sintering.

The local aluminum back surface field 2 comprises a set of parallel straight strip groups uniformly distributed in the rear passivation coating 1.

It should be noted that the silicon substrate 5 of the present invention is a P-type silicon, which is formed by slicing a crystal bar generated by growth of a P-type silicon starting material crystal into (for example, but not limited to) 156 mm × 156 mm slices.

The solar cell is printed with a highly conductive aluminum paste, wherein the conductivity of the highly conductive aluminum paste is 1 × 10⁻⁶-2 × 10⁻⁵ Ω·cm; the grooves on the local aluminum back surface electric field 2 have a width of 10-25 µm and a depth of 120-150 nm, leading to a reduced contact resistance; the distance between two adjacent grooves on the local aluminum back surface electric field 2 is 0.6-1 mm, leading to less metallization recombination; the linear aluminum paste has a width of 15-50 µm and a distance between two adjacent linear aluminum pastes of 0.6-1 mm. The small groove width in the local aluminum back surface field causes less metal recombination, and thus the photoelectric conversion efficiency of the solar cell of the present invention is improved.

The solar cell prepared according to the above method was subjected to the following experiment:
Comparative Example 1: a common solar cell without a local aluminum back surface field;
Comparative Example 2: a solar cell with a local aluminum back surface field prepared by laser grooving and screen printing;
Comparative Example 3: a solar cell with a local aluminum back surface field prepared by printing with an inorganic etching paste proposed in the prior art;

### Example:

A solar cell with a local aluminum back surface field was prepared by printing an inorganic etching paste with the method of the present invention, wherein except for different steps for preparing the local aluminum back surface field, methods for preparing the rest layers were the same. Comparison of the specific experimental results is shown in Table 1:

**Table 1. Comparison of experimental results**

| Test object | Comparative Example 1 | Comparative Example 2 | Comparative Example 3 | Example |
|---|---|---|---|---|
| Open-circuit voltage (V) | 0.644 | 0.678 | 0.682 | 0.691 |
| Short-circuit current (A) | 9.526 | 9.898 | 9.747 | 9.752 |
| Series resistance (mΩ) | 1.821 | 2.03 | 2.10 | 2.02 |
| Fill factor (ff) | 81.05 | 80.73 | 80.72 | 81.03 |
| Photoelectric conversion efficiency (%) | 20.37 | 22.16 | 21.96 | 22.05 |

As shown in Table 1, the photoelectric conversion efficiency of a double-sided solar cell prepared by the method of the present invention is improved compared to that in the prior art.

The present invention provides a method for preparing a rear-passivated solar cell, comprising:
S1, selecting a P-type silicon having a size of 156 × 156 mm, and forming a textured surface on a front of the P-type silicon wafer by wet or dry etching with the reflectivity controlled at 10-30%;
S2, performing phosphorus diffusion on the front of the silicon wafer treated in S1, and forming an N-type emission electrode, for example, by thermal diffusion or ion implantation, wherein the diffusion of the silicon wafer is preferably performed using phosphorus oxychloride, and the sheet resistance is controlled at 75-100 ohm/sq during the diffusion;
S3, removing phosphorosilicate glass formed in the diffusion process on the basis of S2, and removing a phosphorosilicate glass layer formed in the diffusion process on a front of the N-type emission electrode and a rear of the P-type silicon wafer with an HF solution;
S4, depositing an 8-12-nm thick layer of aluminum oxide or silicon dioxide on the rear of the silicon wafer using a PVECD device, depositing a 70-80-nm thick layer of silicon nitride on the aluminum oxide layer or silicon dioxide layer using a PVECD device to finally form a rear passivation layer;
It should be noted that PECVD refers to Plasma Enhanced Chemical Vapor Deposition. PECVD is a process in which a gas containing atoms constituting a thin film is ionized by means of microwave, radio frequency or other technologies to form a plasma locally. The plasma is easily reacted to deposit a desired thin film on a substrate due to its strong chemical activity.
S5, forming a silicon nitride anti-reflection passivation coating on the front of the silicon wafer;
S6, printing an inorganic etching paste on the rear of the silicon wafer by screen printing or ink-jet printing, wherein the inorganic etching paste is parallel printed on the rear passivation layer and dried; the inorganic etching paste etches the rear passivation layer in a sintering process at 300-450 °C, and the aluminum paste fills the straight grooves to form a local aluminum back surface field for connecting an all-aluminum back surface electric field and the P-type silicon;
S7, printing a linear highly conductive aluminum paste in the grooves on the rear of the silicon wafer to cover the inorganic etching paste to form a local aluminum back surface field and drying, and printing a rear electrode silver paste on the rear of the silicon wafer and drying; and
S8, sintering the silicon wafer at 730-770 °C, during which the inorganic etching paste etches the rear passivation layer to form the local aluminum back surface field for connecting the all-aluminum back surface electric field and the P-type silicon.

The present invention is further illustrated by the specific examples below:

### Example 1

A method for preparing a local aluminum back surface field solar cell, comprising:
S1, a P-type silicon having a size of 156 × 156 mm was selected, and a textured surface on a front of the P-type silicon wafer was formed by wet or dry etching with the reflectivity controlled at 20%;
S2, phosphorus diffusion was performed on the front of the silicon wafer treated in S1, and an N-type emission electrode was formed, for example, by thermal diffusion or ion implantation, wherein the diffusion of the silicon wafer was preferably performed using phosphorus oxychloride, and the sheet resistance was controlled at 90 ohm/sq during the diffusion;
S3, phosphorosilicate glass formed in the diffusion process on the basis of S2 was removed, and a phosphorosilicate glass layer formed in the diffusion process on a front of the N-type emission electrode and a rear of the P-type silicon wafer was removed with an HF solution;
S4, a 7-nm thick layer of aluminum oxide or silicon dioxide on the rear of the silicon wafer was deposited using a PVECD device, a 85-nm thick layer of silicon nitride was deposited on the aluminum oxide layer or silicon dioxide layer using a PVECD device to finally form a rear passivation layer;
S5, a silicon nitride anti-reflection passivation coating was formed on the front of the silicon wafer;
S6, the rear electrode was printed, and an inorganic etching paste on the rear of the silicon wafer was printed by screen printing or ink-jet printing, wherein the inorganic etching paste was parallel printed on the rear passivation layer and dried; the rear passivation layer in a sintering process was etched at 375 °C with the inorganic etching paste, and the straight grooves were filled with the aluminum paste to form a local aluminum back surface field for connecting an all-aluminum back surface electric field and the P-type silicon;
S7, a linear highly conductive aluminum paste was printed in the grooves on the rear of the silicon wafer to cover the inorganic etching paste to form a local aluminum back surface field and dried, and a rear electrode silver paste was printed on the rear of the silicon wafer and dried; and
S8, the silicon wafer was sintered at 750 °C, during which the rear passivation layer was etched with the inorganic etching paste to form the local aluminum back surface field for connecting the all-aluminum back surface electric field and the P-type silicon, so as to give a double-sided solar cell.

### Example 2

S1, a P-type silicon having a size of 156 × 156 mm was selected, and a textured surface on a front of the P-type silicon wafer was formed by wet or dry etching with the reflectivity controlled at 10%;
S2, phosphorus diffusion was performed on the front of the silicon wafer treated in S1, and an N-type emission electrode was formed, for example, by thermal diffusion or ion implantation, wherein the diffusion of the silicon wafer was preferably performed using phosphorus oxychloride, and the sheet resistance was controlled at 75 ohm/sq during the diffusion;
S3, phosphorosilicate glass formed in the diffusion process on the basis of S2 was removed, and a phosphorosilicate glass layer formed in the diffusion process on a front of the N-type emission electrode and a rear of the P-type silicon wafer was removed with an HF solution;
S4, a 8-nm thick layer of aluminum oxide or silicon dioxide on the rear of the silicon wafer was deposited using a PVECD device, a 70-nm thick layer of silicon nitride was deposited on the aluminum oxide layer or silicon dioxide layer using a PVECD device to finally form a rear passivation layer;
S5, a silicon nitride anti-reflection passivation coating was formed on the front of the silicon wafer;
S6, the rear electrode was printed, and an inorganic etching paste on the rear of the silicon wafer was printed by screen printing or ink-jet printing, wherein the inorganic etching paste was parallel printed on the rear passivation layer and dried; the rear passivation layer in a sintering process was etched at 300 °C with the inorganic etching paste, and the straight grooves were filled with the aluminum paste to form a local aluminum back surface field for connecting an all-aluminum back surface electric field and the P-type silicon;
S7, a linear highly conductive aluminum paste was printed in the grooves on the rear of the silicon wafer to cover the inorganic etching paste to form a local aluminum back surface field and dried, and a rear electrode silver paste was printed on the rear of the silicon wafer and dried; and
S8, the silicon wafer was sintered at 730 °C, during which the rear passivation layer was etched with the inorganic etching paste to form the local aluminum back surface field for connecting the all-aluminum back surface electric field and the P-type silicon, so as to give a double-sided solar cell.

### Example 3

S1, a P-type silicon having a size of 156 × 156 mm was selected, and a textured surface on a front of the P-type silicon wafer was formed by wet or dry etching with the reflectivity controlled at 30%;
S2, phosphorus diffusion was performed on the front of the silicon wafer treated in S1, and an N-type emission electrode was formed, for example, by thermal diffusion or ion implantation, wherein the diffusion of the silicon wafer was preferably performed using phosphorus oxychloride, and the sheet resistance was controlled at 75 ohm/sq during the diffusion;
S3, phosphorosilicate glass formed in the diffusion process on the basis of S2 was removed, and a phosphorosilicate glass layer formed in the diffusion process on a front of the N-type emission electrode and a rear of the P-type silicon wafer was removed with an HF solution;
S4, a 8-nm thick layer of aluminum oxide or silicon dioxide on the rear of the silicon wafer was deposited using a PVECD device, a 70-nm thick layer of silicon nitride was deposited on the aluminum oxide layer or silicon dioxide layer using a PVECD device to finally form a rear passivation layer;
S5, a silicon nitride anti-reflection passivation coating was formed on the front of the silicon wafer;
S6, the rear electrode was printed, and an inorganic etching paste on the rear of the silicon wafer was printed by screen printing or ink-jet printing, wherein the inorganic etching paste was parallel printed on the rear passivation layer and dried; the rear passivation layer in a sintering process was etched at 300 °C with the inorganic etching paste, and the straight grooves were filled with the aluminum paste to form a local aluminum back surface field for connecting an all-aluminum back surface electric field and the P-type silicon;
S7, a linear highly conductive aluminum paste was printed in the grooves on the rear of the silicon wafer to cover the inorganic etching paste to form a local aluminum back surface field and dried, and a rear electrode silver paste was printed on the rear of the silicon wafer and dried; and
S8, the silicon wafer was sintered at 770 °C, during which the rear passivation layer was etched with the inorganic etching paste to form the local aluminum back surface field for connecting the all-aluminum back surface electric field and the P-type silicon, so as to give a double-sided solar cell.

Finally it should be noted that the above examples are only for illustrating the technical schemes of the present invention but not for limiting the protection scope of the present invention. Although the present invention is described in detail with reference to the preferred schemes, it should be understood by those skilled in the art that modifications or equivalent substitutions can be made to the technical schemes of the present invention without departing from the spirit and scope of the technical schemes of the present invention.

## Claims

1. A double-sided solar cell, comprising a silicon substrate (5); an N-type emission electrode (6), a font-side passivation anti-reflection coating (7) and a front electrode (3) arranged in a bottom-to-top sequence on a front of the silicon substrate (5); and a rear passivation coating (1), a back surface electric field and a rear electrode (4) arranged in a bottom-to-top sequence on a rear of the silicon substrate, wherein the solar cell is a double-sided solar cell; the back surface electric field is a local aluminum back surface electric field (2); the local aluminum back surface electric field (2) is provided with linear grooves by etching the rear passivation coating (1) with an inorganic etching paste, and the grooves are covered with a highly conductive aluminum paste; the solar cell has a BSF layer of 2-5 µm thick.

2. The double-sided solar cell according to claim 1, wherein the inorganic etching paste is an inorganic non-metal etching paste.

3. The double-sided solar cell according to claim 1, wherein the local aluminum back surface field (2) comprises a set of parallel straight strip groups uniformly distributed in the rear passivation coating (1); the grooves on the local aluminum back surface electric field (2) have a width of 10-25 µm and an etching depth of 120-150 nm, and a distance between two adjacent grooves of 0.6-1 mm.

4. The double-sided solar cell according to claim 1, wherein the highly conductive aluminum paste has conductivity of 1 × 10⁻⁶-2 × 10⁻⁵ Ω·cm; the linear highly conductive aluminum paste has a width of 15-50 µm, and a distance between two adjacent linear highly conductive aluminum pastes of 0.6-2 mm.

5. The double-sided solar cell according to claim 1, wherein the silicon substrate (5) is a P-type crystalline silicon wafer, and the P-type silicon is formed by slicing a crystal bar generated by growth of a P-type silicon starting material crystal.

6. A method for preparing the double-sided solar cell according to claim 1, comprising:
S1, silicon wafer selection, texturing, and cleaning: selecting a P-type silicon having a size of 156 × 156 mm, and forming a textured surface on a front of the P-type silicon wafer by wet or dry etching with the reflectivity controlled at 10-30%;
S2, phosphorus diffusion: performing phosphorus diffusion on the front of the silicon wafer treated in S1, and forming an N-type emission electrode, for example, by thermal diffusion or ion implantation, wherein the diffusion of the silicon wafer is preferably performed using phosphorus oxychloride, and the sheet resistance is controlled at 75-100 ohm/sq during the diffusion;
S3, back junction removal: removing phosphorosilicate glass formed in the diffusion process on the basis of S2, and removing a phosphorosilicate glass layer formed in the diffusion process on a front of the N-type emission electrode and a rear of the P-type silicon wafer with an HF solution;
S4, deposition of a rear passivation coating: depositing an 8-12-nm thick layer of aluminum oxide or silicon dioxide on the rear of the silicon wafer using a PVECD device, depositing a 70-80-nm thick layer of silicon nitride on the aluminum oxide layer or silicon dioxide layer using a PVECD device to finally form a rear passivation layer;
S5, deposition of a front anti-reflection passivation coating: forming a silicon nitride anti-reflection passivation coating on the front of the silicon wafer;
S6, rear electrode printing, and grooves etching on the rear passivation coating by printing an organic etching paste: printing an inorganic etching paste on the rear of the silicon wafer by screen printing or ink-jet printing, wherein the inorganic etching paste is parallel printed on the rear passivation layer and dried; the inorganic etching paste etches the rear passivation layer in a sintering process at 300-450 °C, and the aluminum paste fills the straight grooves to form a local aluminum back surface field for connecting an all-aluminum back surface electric field and the P-type silicon;
S7, groove covering with a linear aluminum paste, and front electrode printing: printing a linear highly conductive aluminum paste in the grooves on the rear of the silicon wafer to cover the inorganic etching paste to form a local aluminum back surface field and drying, and printing a rear electrode silver paste on the rear of the silicon wafer and drying; and
S8, sintering to give a local aluminum back surface field: sintering the silicon wafer at a high temperature, during which the inorganic etching paste etches the rear passivation layer to form the local aluminum back surface field for connecting the all-aluminum back surface electric field and the P-type silicon.

7. The method according to claim 6, wherein the thickness of the Al₂O₃ or the SiOₓ layer in S4 is 2-12 nm, and the thickness of the SiNₓ layer is 70-100 nm.

8. The method according to claim 6, wherein the groove etching temperature of the inorganic etching paste in S6 is 200-450 °C.

9. The method according to claim 6, wherein the sintering temperature of the aluminum paste in S8 is 730-770 °C.
